# EUROPEAN PATENT APPLICATION

(11) **EP 4 832 702 A1**
(43) Date of publication of application: **28.10.2026**
(21) Application number: 24918869.9
(22) Date of filing: 16.01.2024
(51) Int. Cl.: H10H 20/855

(54) **LIGHT-EMITTING ELEMENT PACKAGE AND DISPLAY DEVICE USING SAME**

(71) Applicant: LG Electronics Inc., Yeongdeungpo-gu Seoul 07336 (KR)
(72) Inventor: CHOI, Hwanjoon, Seoul 06772 (KR); LEE, Yonghan, Seoul 06772 (KR); WI, Kyoungtae, Seoul 06772 (KR); KANG, Daesung, Seoul 06772 (KR)
(74) Representative: Vossius & Partner Patentanwälte Rechtsanwälte mbB
(86) International application number: PCT/KR2024/000744
(87) International publication number: WO 2025/154834

(57) **Abstract**

The present disclosure is applicable to technical fields related to display devices, and for example, relates to a light-emitting element package and a display device using a light-emitting diode (LED). The present disclosure may include: a first layer having a terminal unit; a second layer positioned adjacent to the first layer and having a light-emitting unit including light-emitting elements constituting a unit subpixel; a third layer which emits light emitted from the light-emitting unit; and a fourth layer located between the second layer and the third layer and including a scattering unit which is located in a first area locally defining a position corresponding to at least a portion of the light emitting unit, and includes first filler particles.

## Description

### TECHNICAL FIELD

The present disclosure is applicable to a technology field related to a display device, and, for example, relates to a light-emitting element package and a display device using a light emitting diode (LED).

### BACKGROUND

In a field of a display technology, display devices having excellent characteristics such as thinness, flexibility, and the like have been developed. On the other hand, currently commercialized major displays are represented by a LCD (liquid crystal display) and an OLED (organic light emitting diode).

On the other hand, LED (light emitting diode), which is a well-known semiconductor light emitting element that converts electric current into light, has been used as a light source for a display image of an electronic device including an information and communication device along with a GaP:N-based green LED, starting with commercialization of a red LED using a GaAsP compound semiconductor in 1962.

Recently, the light-emitting diode (LED) has been gradually miniaturized to be manufactured into a micrometer-sized LED which is used as a pixel of the display device.

The LED exhibits characteristics of low power, high luminance, and high reliability compared to other types of display elements/panels, and may be applied to a flexible element. Therefore, research thereon has been actively conducted in research institutes and companies in recent years.

Various markets of the LED display are expanding into applications that utilize the characteristics of the high luminance and high reliability of the LED. The field that is leading the market due to these characteristics is a signage display.

In such a display, the LED may be manufactured in the form of a package that may be used as a unit pixel. When a mini LED having a size of a millimeter scale is used, such a LED package may include a support layer generally including a sapphire substrate. In general, the support layer may be relatively much thicker than the light-emitting layer included in the LED.

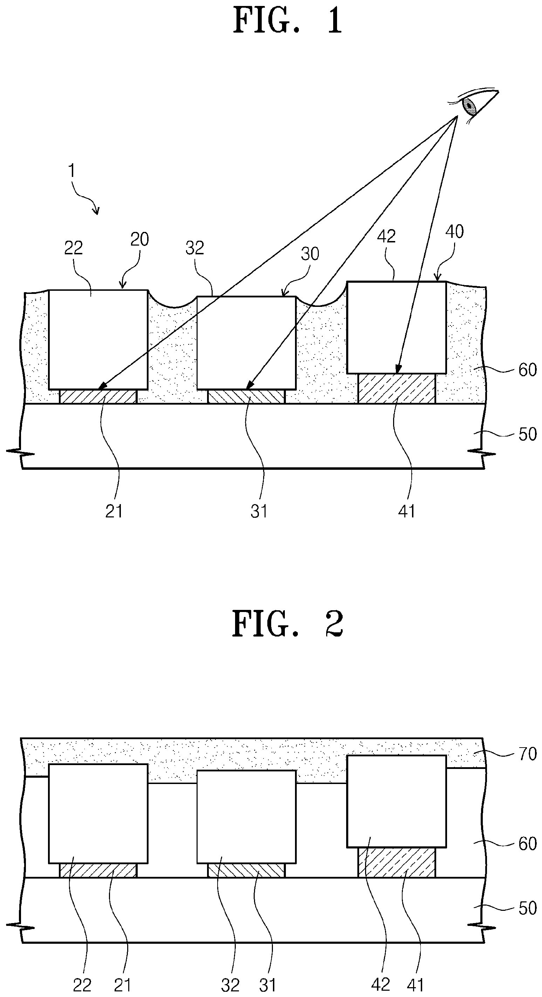

FIG. 1 is a schematic view showing a viewing angle distribution in an example of a display device using a general light emitting device. FIG. 2 is a schematic view showing another example of the display device using the general light emitting device.

Referring to FIG. 1, in a display device 1 that uses light sources 20, 30, and 40 using light emitting devices such as mini-LEDs, the light sources 20, 30, and 40 may be disposed on a substrate 50, and an insulating layer 60 configured to cover the areas between the light sources 20, 30, and 40 may be located.

In the event of a difference in refractive index between substrates, such as sapphire substrates, of the light sources 20, 30, and 40 and a material 60 surrounding the substrates, a light path of the light sources 20, 30, and 40 may be laterally restricted, resulting in a change in luminance of each of the light sources 20, 30, and 40 depending on the angle at which a user views the display device.

Referring to FIG. 1, the light sources 20, 30, and 40, which emit different colors of light, may have different thicknesses. In an example, the thicknesses of semiconductor layers 21, 31, and 41 of the light sources 20, 30, and 40 may be different, and the thicknesses of the substrates 22, 32, and 42 may also be different.

In this case, the difference in thickness of the substrates 22, 32, and 42 and the difference in size of the semiconductor layers 21, 31, and 41 may cause a change in the orientation angle. In an example, the amount of light emitted to the side is proportional to the thickness of the substrate 22, 32, and 42, which may cause large light loss.

To overcome this phenomenon, as shown in FIG. 2, a scattering layer 70 covering the substrates 22, 32, and 42 of the respective light sources 20, 30, and 40 may be provided. The scattering layer 70 may contain scattering particles.

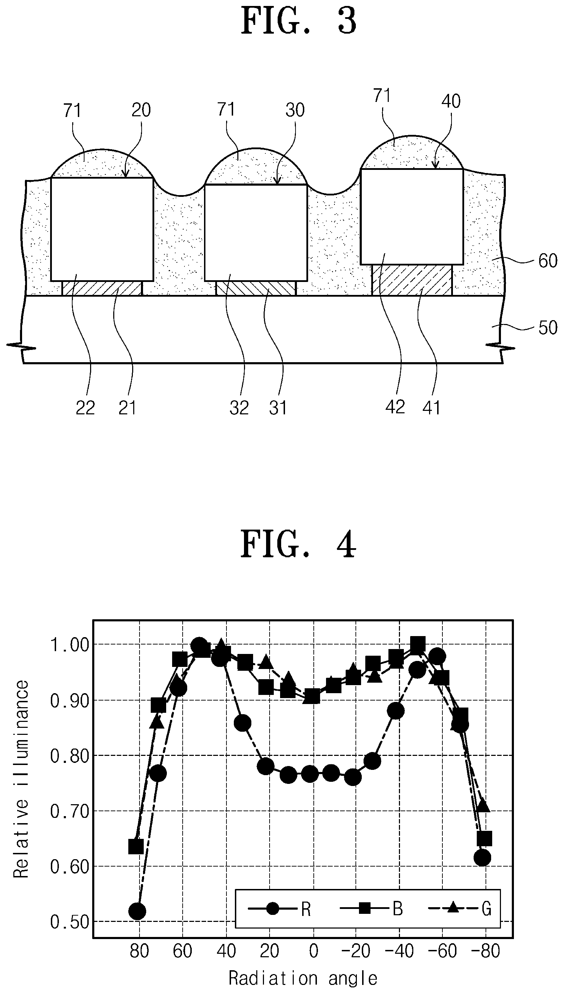

As shown in FIG. 3, a scattering layer 71 having a lens shape is also used on the substrates 22, 32, and 42 of the respective light sources 20, 30, and 40.

The light sources 20, 30, and 40 that use light emitting devices such as mini-LEDs have a Lambertian light characteristic where the amount of light smoothly decreases with angle if light is emitted from only flat surfaces of the light source 20, 30, and 40.

However, LEDs have various orientation angle shapes according to various shape structures, and RGB LEDs with different material compositions also have structural differences such as different side shapes.

Even in a light source in the form of a light emitting device package including a micro-LED, the orientation angle of the light emitted to the outside of the light source in the form of a light emitting device package may be different between the light sources 20, 30, and 40 depending on an electrode pad of the micro-LED, the structure of a semiconductor layer, a structure surrounding the micro-LED, etc. As a result, there occurs the problem that the color temperature of the display varies depending on the viewing angle of a viewer.

When the scattering layers 70 and 71 are applied, directional angle characteristics may be improved as light emitted from each of the light sources 20, 30, and 40 is diffracted and scattered by scattering particles within the scattering layer.

However, during this process, diffraction may intensify, resulting in reflected light and reduced light efficiency.

The light sources 20, 30, and 40 have different directional angles, and thus different degrees of scattering are required. Accordingly, the type and concentration of scattering particles in the scattering layer may be selected and applied based on a light source of which directional angle characteristics differ significantly from a Lambertian light emission profile. In this case, for another light source with a relatively gentle directional angle, excessive scattering conditions may result in a reduction in efficiency greater than necessary.

Accordingly, a difference in luminous efficiency may occur as exemplarily illustrated in FIG. 4. In FIG. 4, the horizontal axis represents a radiation angle and the vertical axis represents a relative illuminance.

Therefore, there is a need to address these problems.

### DISCLOSURE

### Technical Problem

An object of the present disclosure is to provide a light-emitting element package that minimizes a change in color temperature due to a change in viewing angle of a display, and a display device using the light-emitting element package.

An object of the present disclosure is to provide a light-emitting element package that improves light efficiency and a display device using the light-emitting element package.

An object of the present disclosure is to provide a light-emitting element package that separately improves light efficiency according to the directional angle characteristics of a light-emitting element, and a display device using the light-emitting element package.

According to another embodiment of the present disclosure, those skilled in the art will appreciate, from the overall disclosure of the specification and the accompanying drawings, that additional technical problems not explicitly described herein may also exist.

### Technical Solution

To achieve the above objects, according to a first aspect, the present disclosure provides a first layer including a terminal portion, a second layer that is located adjacent to the first layer and includes a light-emitting portion having light-emitting elements defining a unit subpixel, a third layer through which light emitted from the light-emitting portion is emitted, and a fourth layer that is located between the second layer and the third layer and includes a scattering portion located in a first region that locally defines a position corresponding to at least a portion of the light-emitting portion and including first filler particles.

As an exemplary embodiment, the first region may correspond to a position of at least one of the light-emitting elements.

As an exemplary embodiment, the fourth layer may further include a second region that overlaps at least a portion of the first region and includes second filler particles.

As an exemplary embodiment, a refractive index of the first filler particles may be different from a refractive index of the second filler particles.

As an exemplary embodiment, the light-emitting element package may further include a first-1 region located adjacent to the first region and including third filler particles.

As an exemplary embodiment, the fourth layer may include a transparent layer that defines the first region.

As an exemplary embodiment, the light-emitting element package may further include a column portion located at a position overlapping the light-emitting element in the first region.

As an exemplary embodiment, the column portion includes a first column portion located on a first light-emitting element, and a second column portion located on a second light-emitting element.

As an exemplary embodiment, the first column portion and the second column portion may have different sizes

As an exemplary embodiment, the light-emitting element may include a coating layer including fourth filler particles.

As an exemplary embodiment, the light-emitting element package may further include a connection electrode located between the first layer and the second layer and selectively connecting the light-emitting elements to the terminal portion.

As an exemplary embodiment, the scattering portion may include a transparent insulating layer in which the first filler particles are dispersed.

As an exemplary embodiment, at least one of the light-emitting elements may include a semiconductor layer, and a scattering structure that is located on the semiconductor layer and has an interface facing the semiconductor layer, the interface being formed as a rough surface.

As an exemplary embodiment, the scattering structure may include fifth filler particles.

To achieve the above objects, according to a second aspect, the present disclosure provides a support layer including a terminal portion, a light-emitting layer that is located adjacent to the support layer and includes a light-emitting portion having light-emitting elements defining a unit subpixel, a transmissive layer through which light emitted from the light-emitting portion is emitted, and a scattering layer that is located between the light-emitting layer and the transmissive layer and includes a scattering portion located at a position corresponding to at least a portion of the light-emitting portion and including first filler particles.

As an exemplary embodiment, the scattering portion may be located in a first region locally defined within the scattering layer.

As an exemplary embodiment, the first region may correspond to a position of at least one of the light-emitting elements.

As an exemplary embodiment, the scattering layer may further include a second region that overlaps at least a portion of the first region and includes second filler particles.

As an exemplary embodiment, a light extractor having a rough surface may be provided at an end side of the scattering layer.

To achieve the above objects, according to a third aspect, the present disclosure provides a light-emitting element package defining individual pixels, wherein the light-emitting element package includes a second layer having a light-emitting portion located adjacent to a first layer and including light-emitting elements defining a unit subpixel, a third layer through which light emitted from the light-emitting portion is emitted, and a fourth layer that is located between the second layer and the third layer and includes a scattering portion located in a first region that locally defines a position corresponding to at least a portion of the light-emitting portion and including first filler particles.

### Advantageous Effects

According to an embodiment of the present disclosure, the following effects are obtained.

First, a change in color temperature due to a change in viewing angle of a display may be minimized. Accordingly, light efficiency may be improved.

Light efficiency may be improved individually depending on the directional angle characteristics of a light-emitting element.

According to another embodiment of the present disclosure, additional technical effects not explicitly described herein may also be achieved. A person skilled in the art may understand the full intent of the specifications and drawings.

### BRIEF DESCRIPTION OF THE DRAWINGS

FIG. 1 is a schematic diagram showing a viewing angle distribution in an example of a display device using a general light-emitting element.
FIG. 2 is a schematic diagram showing another display device using a general light-emitting element.
FIG. 3 is a schematic diagram showing another display device using a general light-emitting element.
FIG. 4 is a graph showing differences in luminous efficiency among light-emitting elements.
FIG. 5 is a plan view showing a light-emitting element package according to a first embodiment of the present disclosure.
FIG. 6 is a cross-sectional view along line A-A' of FIG. 5.
FIG. 7 is a plan view showing a modified example of a light-emitting element package according to the first embodiment of the present disclosure.
FIG. 8 is a cross-sectional view showing a modified example of a light-emitting element package according to the first embodiment of the present disclosure.
FIGS. 9 to 13 are plan views showing modified examples of a light-emitting element package according to the first embodiment of the present disclosure.
FIG. 14 is a plan view of a light-emitting element package according to a second embodiment of the present disclosure.
FIG. 15 is a cross-sectional view of a light-emitting element package according to the second embodiment of the present disclosure.
FIGS. 16 and 17 are plan views showing modified examples of a light-emitting element package according to the second embodiment of the present disclosure.
FIG. 18 is a plan view of a light-emitting element package according to a third embodiment of the present disclosure.
FIG. 19 is a cross-sectional view of a light-emitting element package according to the third embodiment of the present disclosure.
FIGS. 20 and 21 are plan views showing modified examples of a light-emitting element package according to the third embodiment of the present disclosure.
FIG. 22 is a plan view of a light-emitting element package according to a fourth embodiment of the present disclosure.
FIG. 23 is a cross-sectional view of a light-emitting element package according to the fourth embodiment of the present disclosure.
FIGS. 24 and 25 are plan views showing modified examples of a light-emitting element package according to the fourth embodiment of the present disclosure.
FIG. 26 is a cross-sectional view of a light-emitting element package according to a fifth embodiment of the present disclosure.
FIGS. 27 to 29 are cross-sectional views showing light-emitting elements of the light-emitting element package according to the fifth embodiment of the present disclosure.
FIG. 30 is a plan view showing a modified example of a light-emitting element package according to the fifth embodiment of the present disclosure.
FIG. 31 is a plan view of a light-emitting element package according to a sixth embodiment of the present disclosure.
FIG. 32 is a cross-sectional view of a light-emitting element package according to the sixth embodiment of the present disclosure.

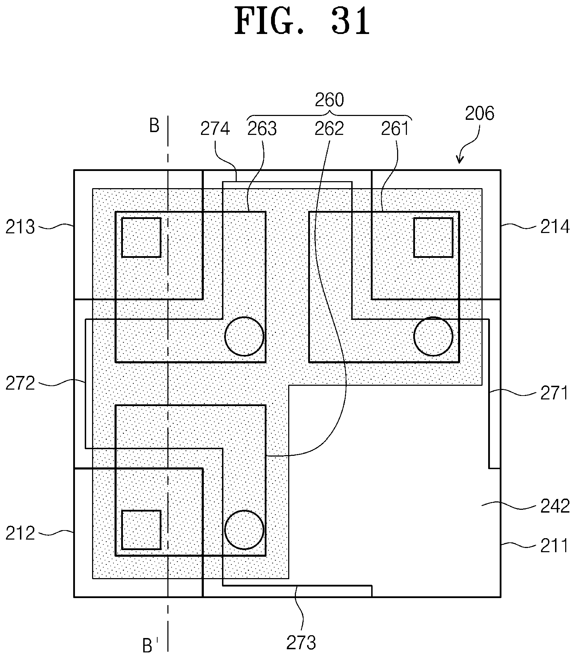

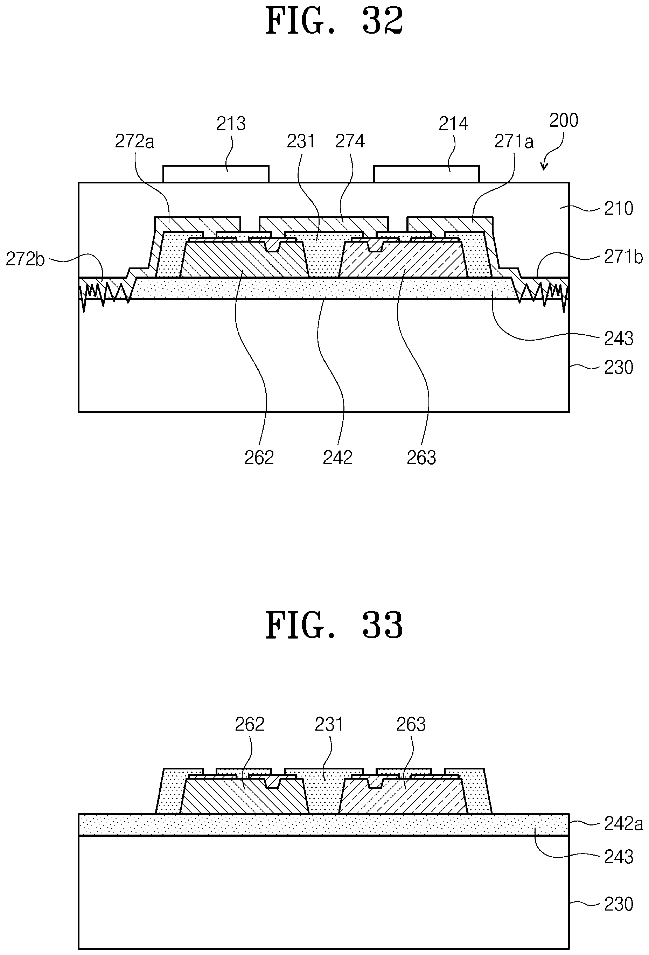

FIG. 32 shows a cross-section along line B-B' of FIG. 31.
FIGS. 33 to 35 are schematic cross-sectional views illustrating a manufacturing process of a light extractor of a light-emitting element package according to the sixth embodiment of the present disclosure.

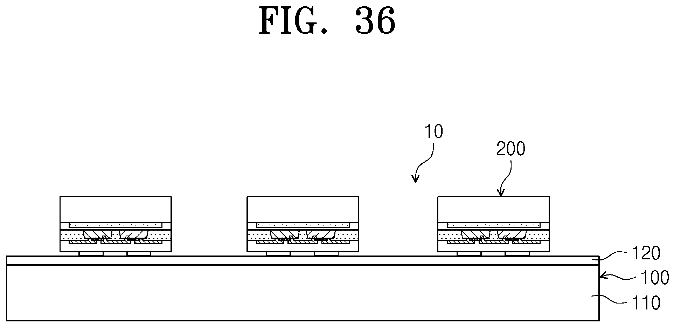

FIG. 36 is a schematic cross-sectional view showing a display device using a light-emitting element package according to the first embodiment of the present disclosure.

### DETAILED DESCRIPTION

Reference will now be made in detail to embodiments of the present disclosure, examples of which are illustrated in the accompanying drawings. Wherever possible, the same reference numbers will be used throughout the drawings to refer to the same or like parts, and redundant description thereof will be omitted. As used herein, the suffixes "module" and "unit" are added or used interchangeably to facilitate preparation of this specification and are not intended to suggest distinct meanings or functions. In describing embodiments disclosed in this specification, relevant well-known technologies may not be described in detail in order not to obscure the subject matter of the embodiments disclosed in this specification. In addition, it should be noted that the accompanying drawings are only for easy understanding of the embodiments disclosed in the present specification, and should not be construed as limiting the technical spirit disclosed in the present specification.

Furthermore, although the drawings are separately described for simplicity, embodiments implemented by combining at least two or more drawings are also within the scope of the present disclosure.

In addition, when an element such as a layer, region or module is described as being "on" another element, it is to be understood that the element may be directly on the other element or there may be an intermediate element between them.

In addition, the semiconductor light emitting device mentioned in this specification is a concept including an LED, a micro LED, and the like, which may be used in a mixed manner.

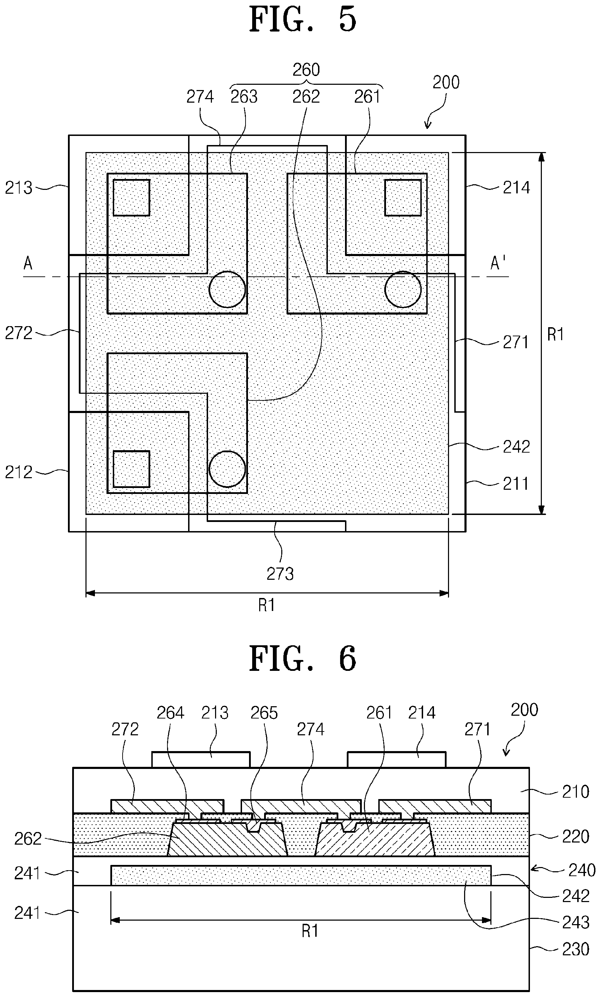

FIG. 5 is a plan view showing a light-emitting element package according to a first embodiment of the present disclosure. FIG. 6 is a cross-sectional view along line A-A' of FIG. 5.

Referring to FIGS. 5 and 6, a light-emitting element package 200 of a bottom emission type, in which light is emitted in a downward direction, is shown.

The light-emitting element package 200 according to the first embodiment may include a first layer (support layer) 210 having terminal portions 211, 212, 213, and 214, a second layer (light-emitting layer) 220 located adjacent to the first layer 210 and including light-emitting elements 261, 262, 263; 260 that define a unit subpixel, a third layer (transmissive layer) 230 through which light emitted from the light-emitting portion 260 passes, and a fourth layer (scattering layer) 240 including a scattering portion 242 located within a first region R1 that locally defines a position corresponding to at least a portion of the light-emitting portion 260 and including filler particles (first filler particles) 243.

For example, the light-emitting element package 200 according to the first embodiment may include the transmissive layer 230 that emits light, the scattering layer 240 located on the transmissive layer 230 and including the scattering portion 242 that scatters light emitted from the light-emitting portion 260, and the light-emitting layer 220 located on the scattering layer 240 and including the light-emitting portion 260 having the light-emitting elements 261, 262, and 263 that define a unit subpixel, and the support layer 210 located on the light-emitting layer 220 and including the terminal portions 211, 212, 213, and 214.

Here, a refractive index of the first filler particles may be equal to or greater than 1.3.

For example, the first filler particles 243 may include a plurality of particles having sizes in nanometers (nm) or micrometers (µm).

For example, the first filler particles 243 may include at least one of TiO₂, ZnO₂, ZrO₂, MgF₂, SnO₂, ITO, SiNx, Silica, or PMMA.

The first filler particles 243 may be used for at least one of the purposes of improving a viewing angle to prevent color temperature deviation according to a light emission angle of the light-emitting portion 260 in the second layer 220 and improving the reflectance.

The scattering portion 242 may include a transparent insulating layer. For example, at least one of the first layer 210 to the fourth layer 240 may be formed from at least one material among acrylic, epoxy, silicone, Teflon, silicone acrylic, or silicone epoxy composite.

For example, the scattering portion 242 may be provided with the first filler particles 243 dispersed using such a material as a binder.

For example, a refractive index of a transparent insulating layer that constitutes at least one of the first layer 210 to the fourth layer 240 may be less than or equal to 1.5. The refractive index of any one of the first filler particles 243 may be equal to or greater than 1.6. For example, the first filler particles 243 may include at least one of TiO₂, ZnO₂, or ZrO₂.

As an exemplary embodiment, the first region R1 may correspond to a position of at least one of the light-emitting elements 261, 262, and 263. In the present embodiment, the first region R1 may correspond to a region that includes all of the light-emitting elements 261, 262, and 263. In this case, a density of the first filler particles 243 in the first region R1 may change. For example, the first filler particles 243 with a greater density may be distributed at a position corresponding to a light-emitting element that requires a greater degree of scattering. As another example, the first filler particles 243 with a greater refractive index may be distributed at a position corresponding to a light-emitting element that requires a greater degree of scattering.

For example, any one of different filler particles 243, concentrations, thicknesses, and areas may be applied to a portion of the scattering layer 240 corresponding to each of the light-emitting elements 261, 262, and 263 depending on the characteristics of each of the light-emitting elements 261, 262, and 263. Specific examples of these examples will be described below for each embodiment.

Referring to FIG. 6, the fourth layer 240 that defines a scattering layer may include a transparent layer 241 that defines the first region R1. For example, the entire scattering layer 240 may be formed of a transparent material. In this scattering layer 240, the first region R1 may be provided at a position corresponding to at least one of the light-emitting elements 261, 262, and 263. The first region R1 may be a region excluding an edge side of the scattering layer 240. For example, the scattering layer 240 may include the first region R1 at a position excluding the edge side.

Between the first layer 210 and the second layer 220, connecting electrodes 271, 272, 273, and 274 that selectively connect the light-emitting elements 261, 262, 263; 260 and the terminal portions 211, 212, 213, and 214 may be provided. The terminal portions 211, 212, 213, and 214 may be located on an upper side of the first layer 210.

A first electrode (e.g., P-electrode 264) and a second electrode (e.g., N-electrode 265) of the light-emitting elements 261, 262, 263; 260 may be electrically joined to a first connecting electrode 272 and a second connecting electrode 274 by solder, respectively.

At least one of these connection electrodes 271, 272, 273, and 274 may be fabricated using a redistribution layer (RDL) process used in semiconductor packaging processes. The light-emitting elements 260 may be connected to the connection electrodes 271, 272, 273, and 274 by using the redistribution layer (RDL) process.

The light-emitting elements 260 may include a first light-emitting element 261, a second light-emitting element 262, and a third light-emitting element 263 (see FIG. 5). For example, the first light-emitting element 261 may be a red light-emitting element R, the second light-emitting element 262 may be a green light-emitting element G, and the third light-emitting element 263 may be a blue light-emitting element B. In some cases, at least one of the first light-emitting element 261, the second light-emitting element 262, or the third light-emitting element 263 may include two or more light-emitting elements.

When the light-emitting element package 200 is used in a display device, each of the first light-emitting element 261, the second light-emitting element 262, and the third light-emitting element 263 may correspond to an individual subpixel. The first light-emitting element 261, the second light-emitting element 262, and the third light-emitting element 263 may together form a unit pixel.

The light-emitting elements 260 may be a mini LED with a size in millimeters or a micro LED with a size in micrometers.

Although not illustrated, the light-emitting element package 200 may further include a driving element that drives the light-emitting elements 261, 262, 263; 260. The driving element may be a micro-driver integrated circuit chip (Driver IC) that selectively drives the light-emitting elements 260. In this case, the driving element may be connected to at least one of the light-emitting elements 261, 262, and 263 or the connection electrodes 271, 272, 273, and 274. A detailed explanation thereof is omitted.

As the overall size of the light-emitting elements 261, 262, and 263, such as a micro LED, decreases, a side light-emitting amount relative to a front light-emitting amount is not negligible. For the purpose of redirecting side-emitted light from the light-emitting elements 261, 262, and 263 toward the front, the angle of incidence of light may be controlled by varying the shape of the micro LED chips and the angles of their side surfaces.

By applying the scattering layer 240 including the first filler particles 243 described above, light emitted from the light-emitting elements 261, 262, 263; 260 may be scattered in the scattering portion 242 including the first filler particles 243, thereby minimizing a change in color temperature according to a change in viewing angle of the display.

The light-emitting elements 261, 262, 263; 260 may have different directional angles, and thus may also have different required degrees of scattering. Accordingly, when the type and concentration of scattering particles in the scattering layer are selected and applied based on a light source of which directional angle characteristics differ significantly from a Lambertian light emission profile, other light-emitting elements with a relatively gentle directional angle may have an excessive reduction in efficiency due to excessive scattering conditions.

However, according to an embodiment of the present disclosure, any one of different filler particles 243, concentrations, thicknesses, and areas may be applied to at least some of the light-emitting elements 261, 262, and 263 depending on the characteristics of each of the light-emitting elements 261, 262, and 263.

For example, any one of the filler particles 243 having a greater refractive index, and the scattering portion 242 having a greater concentration, thickness, and area may be applied to the red light-emitting element 261 having a relatively non-uniform viewing angle.

Accordingly, a difference in light distribution according to a viewing angle in the light-emitting element package 200 may be corrected, and the light efficiency may be improved.

For example, when the light-emitting elements 260 such as a micro LED are used, light loss due to lateral light emission due to a small thickness compared to a mini LED may be minimized.

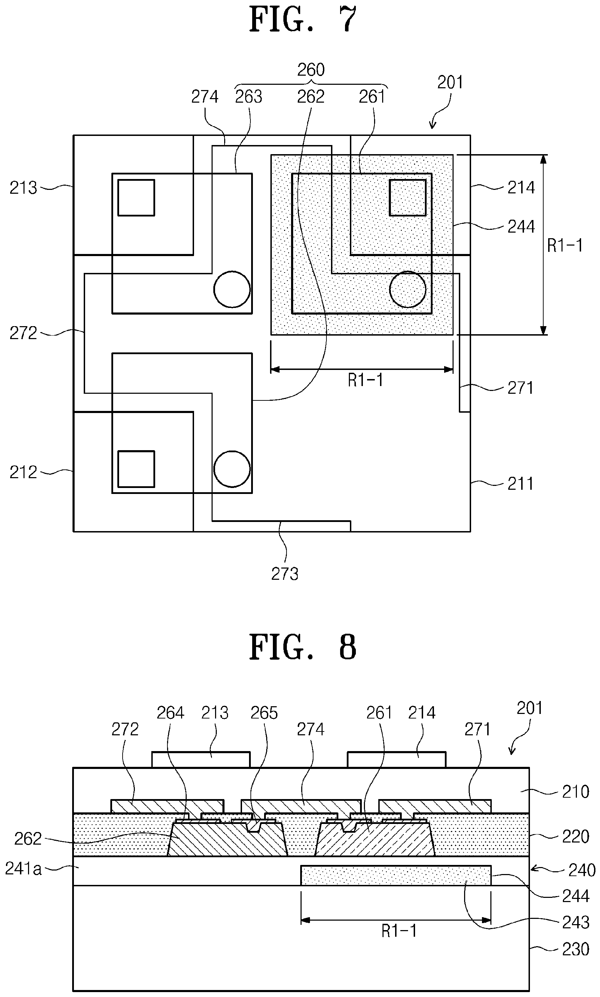

FIG. 7 is a plan view showing a modified example of a light-emitting element package according to the first embodiment of the present disclosure. FIG. 8 is a cross-sectional view showing a modified example of a light-emitting element package according to the first embodiment of the present disclosure.

Referring to FIGS. 7 and 8, in a light-emitting element package 201 according to the modified example, the first region R1 described above may correspond only to a position corresponding to a single light-emitting element. Hereinafter, this region will be referred to as a first-1 region R1-1. For example, as illustrated, a scattering portion 244 including first scattering particles 243 may be provided in the first-1 region R1-1 corresponding to a position of one light-emitting element.

As described above, for example, the scattering portion 244 including the first scattering particles 243 may be provided in the first-1 region R1-1 corresponding to a position of the red light-emitting element 261 having a relatively non-uniform viewing angle. For example, the first-1 region R1-1 may be formed in a position facing the red light-emitting element 261 and substantially in size corresponding to the red light-emitting element 261. Here, "substantial" may mean a size larger than the red light-emitting element 261 but not overlapping a neighboring light-emitting element.

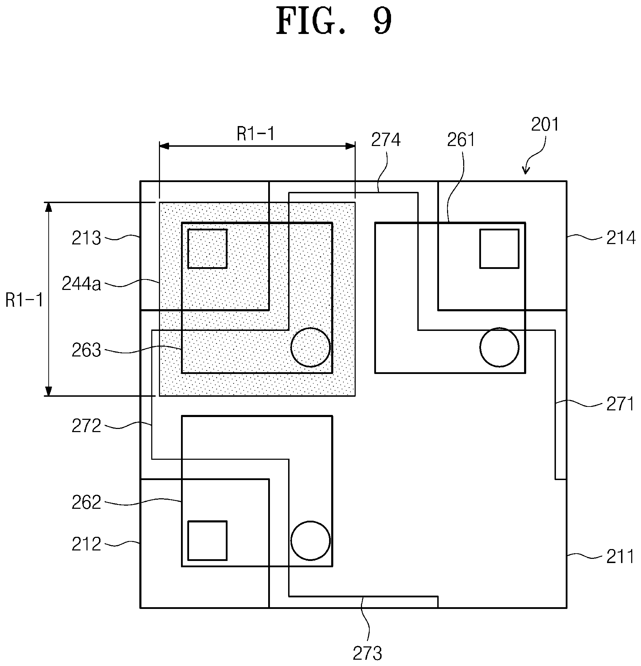

FIGS. 9 to 13 are plan views showing modified examples of a light-emitting element package according to the first embodiment of the present disclosure.

FIG. 9 illustrates an example in which the first-1 region R1-1 is located at a position corresponding to the blue light-emitting element 263, and a scattering portion 244a including the first scattering particles 243 is located in the first-1 region R1-1.

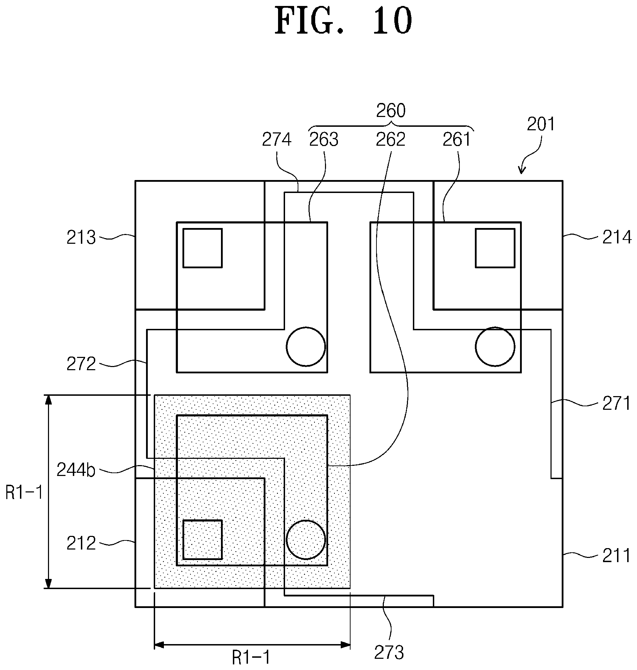

FIG. 10 illustrates an example in which the first-1 region R1-1 is located at a position corresponding to the green light-emitting element 262, and the scattering portion 244b including the first scattering particles 243 is located in the first-1 region R1-1.

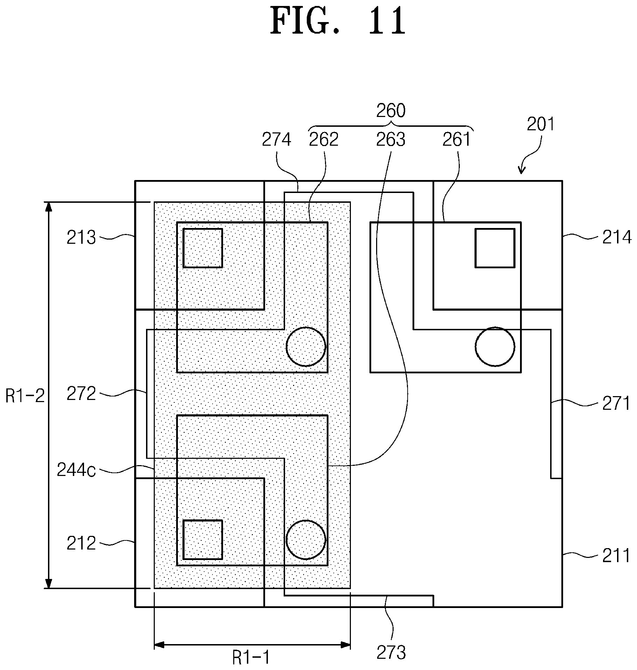

FIG. 11 illustrates an example in which a first-2 region R1-2 is located at a position corresponding to the blue light-emitting element 263 and the green light-emitting element 262, and a scattering portion 244c including the first scattering particles 243 is located in the first-2 region R1-2. For convenience of explanation, a region corresponding to the two light-emitting elements here will be referred to as the first-2 region R1-2.

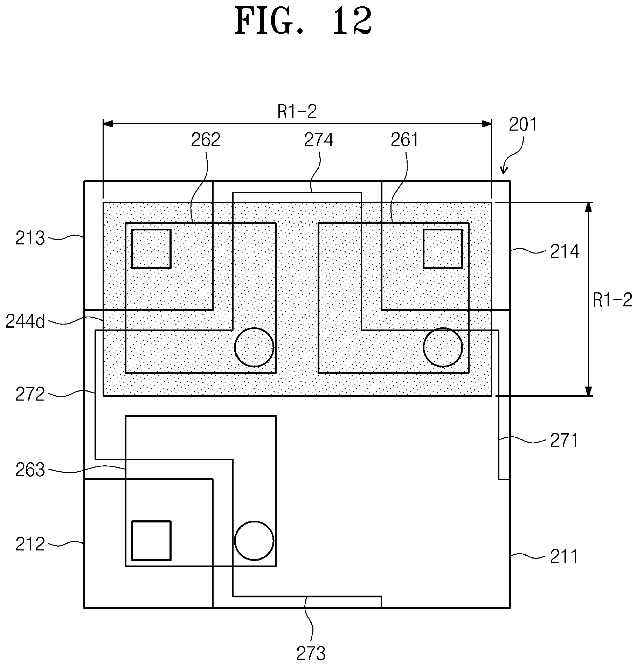

FIG. 12 illustrates an example in which the first-2 region R1-2 is located at a position corresponding to the blue light-emitting element 263 and the red light-emitting element 261, and a scattering portion 244d including the first scattering particles 243 is located in the first-2 region R1-2.

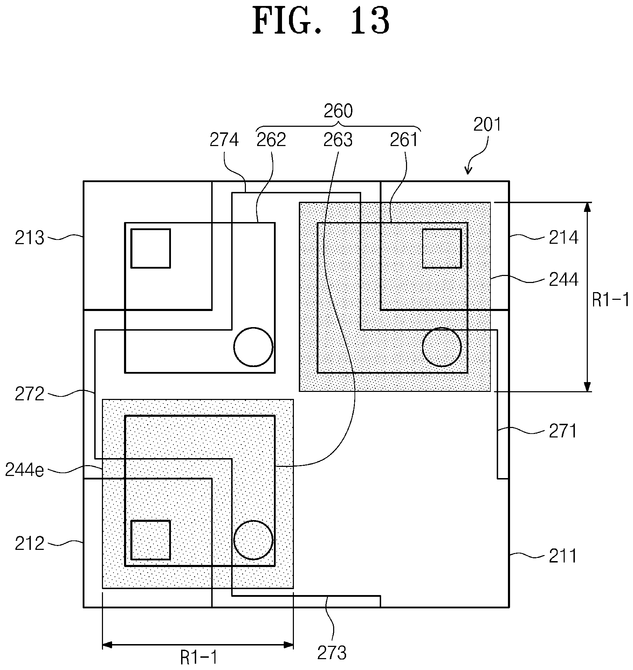

FIG. 13 illustrates an example in which the first-1 region R1-1 is located at a position corresponding to the red light-emitting element 261 and the green light-emitting element 262, and scattering portions 244 and 244e including the first scattering particles 243 are located in the first-1 region R1-1.

As described above, at least one of the refractive index or density (concentration) of the first scattering particles 243 included in each of the scattering portions 244, 244a, 244b, 244c, 244d, and 244e may be different from each other. At least one of the size or thickness of each of the scattering portions 244, 244a, 244b, 244c, 244d, and 244e may differ from each other.

Any parts not otherwise described may be applied in the same way to the description of the first embodiment described above. Therefore, redundant explanations are omitted.

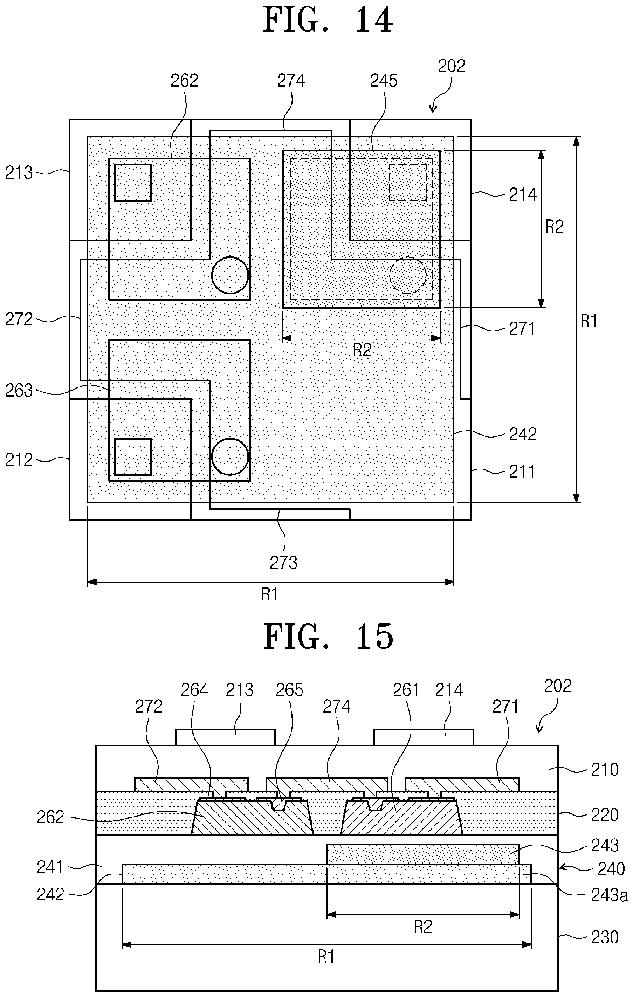

FIG. 14 is a plan view of a light-emitting element package according to a second embodiment of the present disclosure. FIG. 15 is a cross-sectional view of a light-emitting element package according to the second embodiment of the present disclosure.

A light-emitting element package 202 according to the second embodiment may include the first layer (support layer) 210 having the terminal portions 211, 212, 213, and 214, the second layer (light-emitting layer) 220 located adjacent to the first layer 210 and including the light-emitting elements 261, 262, 263; 260 that define a unit subpixel, the third layer (transmissive layer) 230 through which light emitted from the light-emitting portion 260 passes, and the fourth layer (scattering layer) 240 including a scattering portion 242 located in the first region R1 that locally defines a position corresponding to at least a portion of the light-emitting portion 260 and including the filler particles (first filler particles) 243a.

For example, the light-emitting element package 202 according to the second embodiment may include the transmissive layer 230 that emits light, the scattering layer 240 located on the transmissive layer 230 and including the scattering portion 242 that scatters light emitted from the light-emitting portion 260, and the light-emitting layer 220 located on the scattering layer 240 and including the light-emitting portion 260 having the light-emitting elements 261, 262, and 263 that define a unit subpixel, and the support layer 210 located on the light-emitting layer 220 and including the terminal portions 211, 212, 213, and 214.

Here, the scattering layer 240 may further include a second region 245 that overlaps at least a portion of the first region R1 and includes the second filler particles 243.

As an exemplary embodiment, a refractive index of the first filler particles 243a may be different from a refractive index of the second filler particles 243.

At least one of the first filler particles 243a or the second filler particles 243 may include at least one of a metal oxide, a resin particle, or an inorganic oxide. For example, at least one of the first filler particles 243a or the second filler particles 243 may include at least one of TiO₂, ZnO₂, ZrO₂, MgF₂, SnO₂, ITO, SiNx, Silica, or PMMA.

The refractive index of the first filler particles 243a may be the same as the refractive index of the second filler particles 243. For example, when an additional scattering portion 245 corresponding to the second region 245 is located at a position corresponding to the red light-emitting element 261, the density of filler particles 243 and 243a in the second region 245 may be substantially increased.

As an exemplary embodiment, a second region R2 may correspond to a position of any one of the light-emitting elements 261, 262, and 263. In the present embodiment, the first region R1 may correspond to a region that includes all of the light-emitting elements 261, 262, and 263.

Referring to FIG. 14, the fourth layer 240 that defines a scattering layer may include a transparent layer 241 that defines the first region R1. For example, the entire scattering layer 240 may be formed of a transparent material. In this scattering layer 240, the first region R1 may be provided at a position corresponding to at least one of the light-emitting elements 261, 262, and 263. The second region R2 that overlaps at least a portion of the first region R1 and includes the second filler particles 243 may be located.

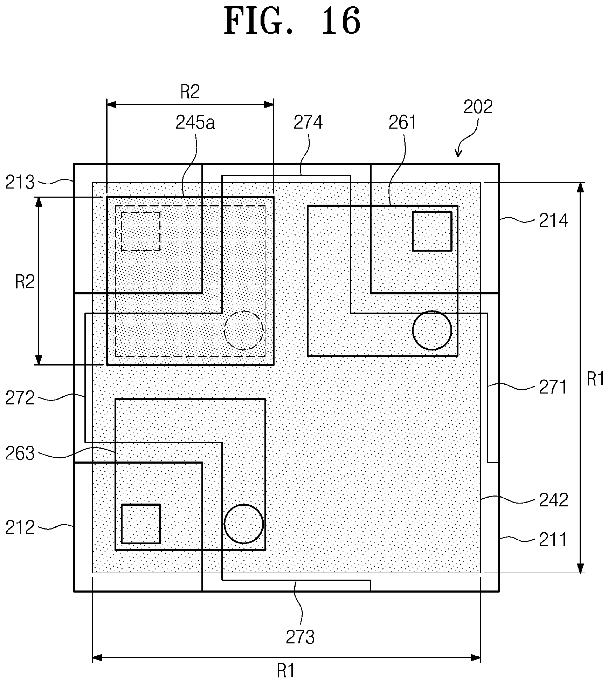

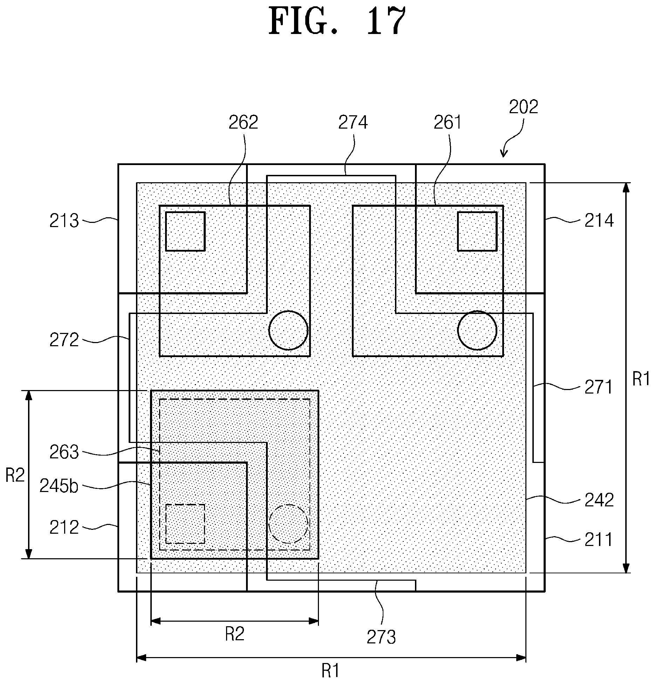

FIGS. 16 and 17 are plan views showing modified examples of a light-emitting element package according to the second embodiment of the present disclosure.

Referring to FIG. 16, an example is shown in which the second region R2 that overlaps at least a portion of the first region R1 and includes the second filler particles 243 is located at a position of the green light-emitting element 262 (245a).

Referring to FIG. 17, an example is shown in which the second region R2 that overlaps at least a portion of the first region R1 and includes the second filler particles 243 is located at a position of the blue light-emitting element 262 (245b).

Any parts not otherwise described may be applied in the same way to the description of the first embodiment described above and modified examples thereof. Therefore, redundant explanations are omitted.

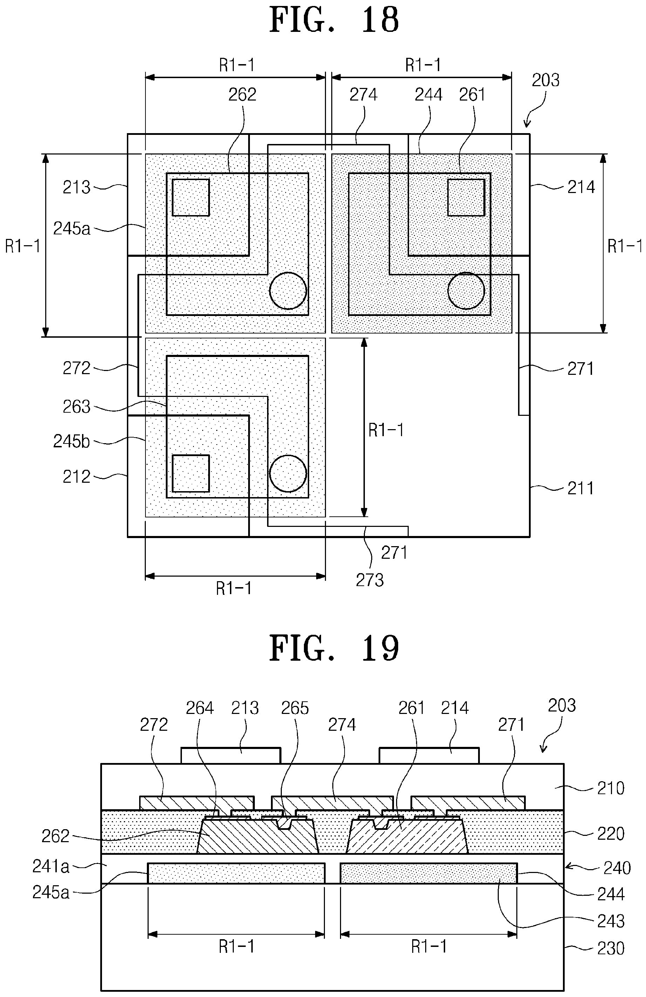

FIG. 18 is a plan view of a light-emitting element package according to a third embodiment of the present disclosure. FIG. 19 is a cross-sectional view of a light-emitting element package according to the third embodiment of the present disclosure.

A light-emitting element package 203 according to the third embodiment may include the first layer (support layer) 210 having terminal portions 211, 212, 213, and 214, the second layer (light-emitting layer) 220 located adjacent to the first layer 210 and including light-emitting elements 261, 262, 263; 260 that define a unit subpixel, the third layer (transmissive layer) 230 through which light emitted from the light-emitting portion 260 passes, and the fourth layer (scattering layer) 240 including the plurality of scattering portions 244, 245a, and 245b located within the first-1 region R1-1 that locally defines a position corresponding to at least two light-emitting elements of the light-emitting portion 260 and including the filler particles (first filler particles) 243.

Referring to FIG. 18, the configuration is shown in which the three scattering portions 244, 245a, and 245b having the first-1 region R1-1 are positioned independently of each other, corresponding to the position of each of the light-emitting elements 261, 262, and 263.

As such, the three scattering portions 244, 245a, and 245b having the first-1 region R1-1 may include the first filler particles 243. In this case, at least two scattering portions 244, 245a, and 245b may include the filler particles 243 having different refractive indices or different densities.

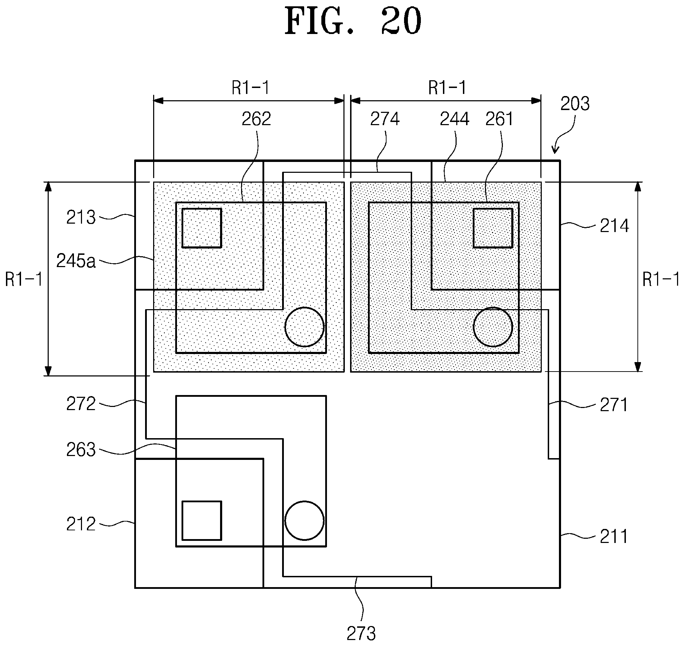

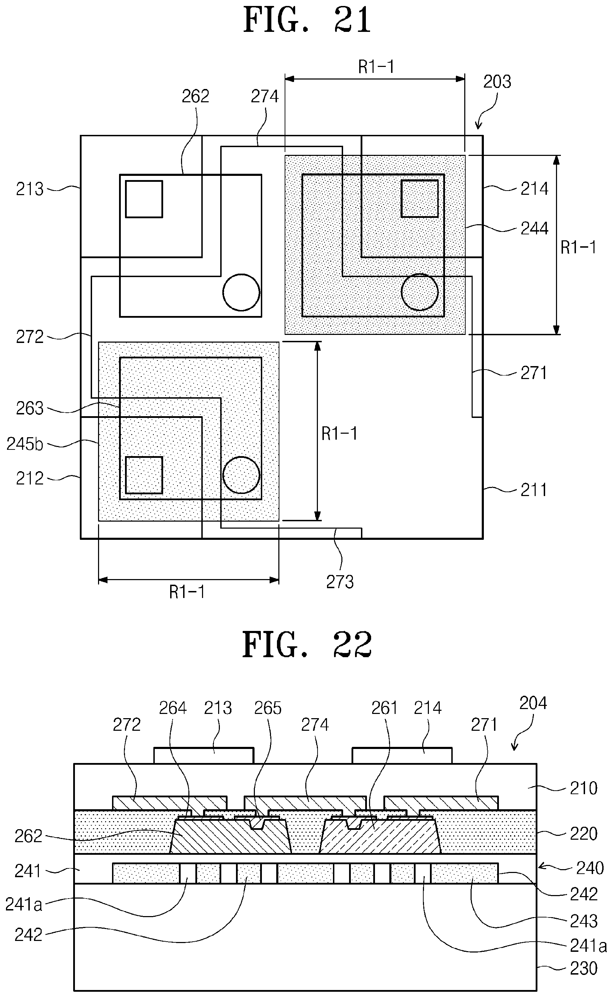

FIGS. 20 and 21 are plan views showing modified examples of a light-emitting element package according to the third embodiment of the present disclosure.

FIG. 20 shows a state in which the scattering portions 244 and 245a are located at the positions of the red light-emitting element 261 and the green light-emitting element 262, respectively.

FIG. 21 shows a state in which the scattering portions 244 and 245b are located at the positions of the red light-emitting element 261 and the blue light-emitting element 263, respectively.

Any parts not otherwise described may be applied in the same way to the description of the first and second embodiments described above and modified examples thereof. Therefore, redundant explanations are omitted.

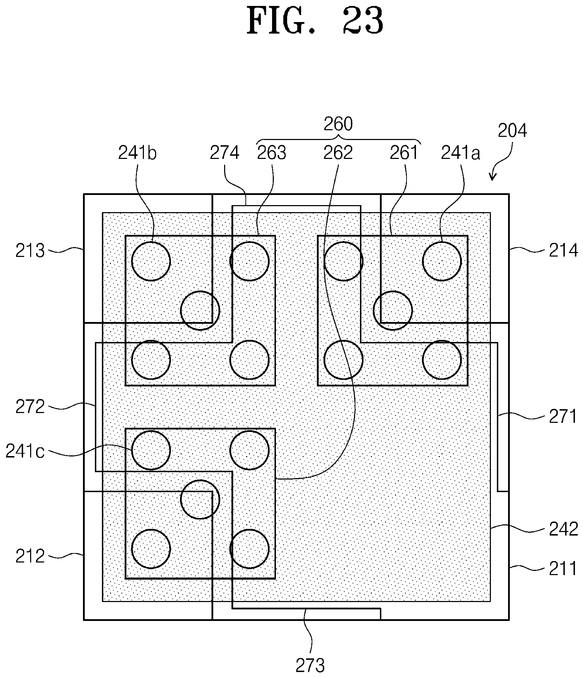

FIG. 22 is a plan view of a light-emitting element package according to a fourth embodiment of the present disclosure. FIG. 23 is a cross-sectional view of a light-emitting element package according to the fourth embodiment of the present disclosure.

A light-emitting element package 204 according to the fourth embodiment may include the first layer (support layer) 210 having the terminal portions 211, 212, 213, and 214, the second layer (light-emitting layer) 220 located adjacent to the first layer 210 and including the light-emitting elements 261, 262, 263; 260 that define a unit subpixel, the third layer (transmissive layer) 230 through which light emitted from the light-emitting portion 260 passes, and the fourth layer (scattering layer) 240 including the scattering portion 242 located at a position corresponding to at least one light-emitting element of the light-emitting portion 260 and including the filler particles (first filler particles) 243.

Referring to FIG. 22, the fourth layer 240 that defines a scattering layer may include the transparent layer 241 that defines a plurality of column portions 241a. For example, the entire scattering layer 240 may be formed of a transparent material.

In the present embodiment, the column portions 241a located at positions overlapping the light-emitting elements 261, 262, and 263 may be provided. The column portions 241a are formed transparently like the transparent layer 241, and thus light emitted from the light-emitting elements 261, 262, and 263 may be transmitted through the column portions 241a.

However, light emitted from the light-emitting elements 261, 262, and 263 may be scattered and emitted to the outside through the remaining area of the scattering portion 242 corresponding to the size of the first region R1 described above.

Referring to FIG. 23, a first column portion 241a may be located at a position of the red light-emitting element 261, a second column portion 241c may be located at a position corresponding to the green light-emitting element 263, and a third column portion 241b may be located at a position of the blue light-emitting element 263. For example, each of these column portions 241a, 241b, and 241c may include the filler particles 243 having at least one of different refractive indices and densities.

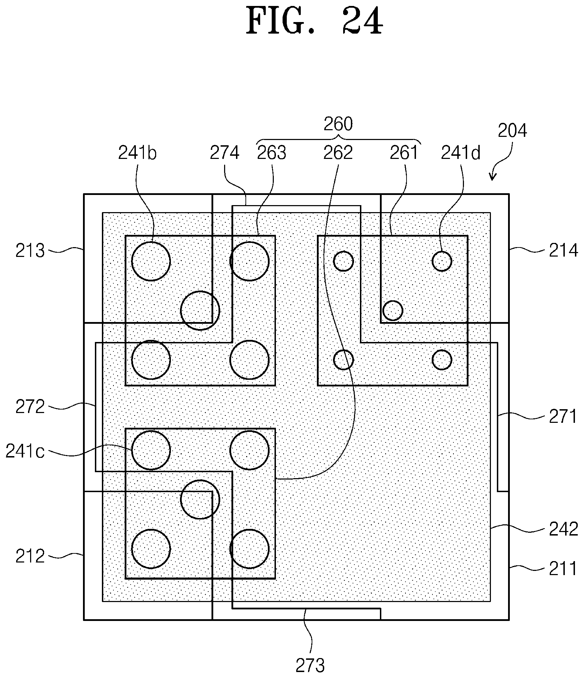

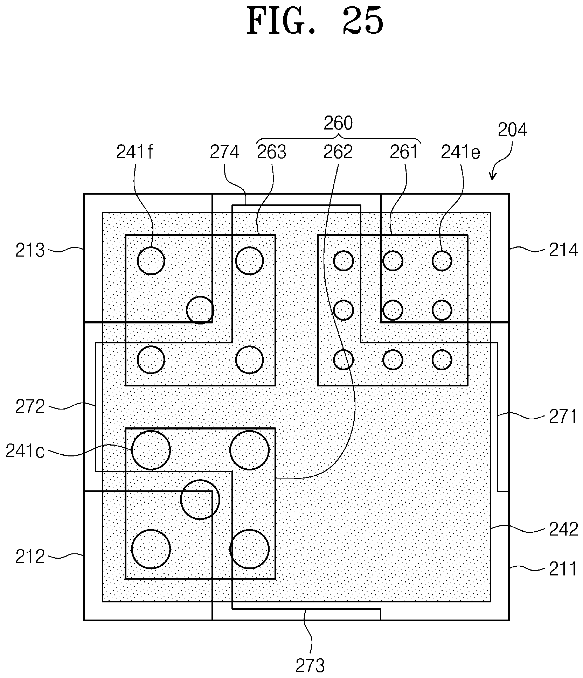

FIGS. 24 and 25 are plan views showing modified examples of a light-emitting element package according to the fourth embodiment of the present disclosure.

Referring to FIGS. 24 and 25, as an exemplary embodiment, the sizes of the respective column portions 241a, 241b, and 241c may differ from each other.

For example, referring to FIG. 24, the size of the first column portion 241a may differ from the sizes of the second column portion 241c and the third column portion 241b. Accordingly, an area through which light emitted from the light-emitting elements 261, 262, and 263 is transmitted may change.

As another example, referring to FIG. 25, the sizes of the first column portion 241a, the second column portion 241c, and the third column portion 241b may differ from each other.

Any parts not otherwise described may be applied in the same way to the description of the first to third embodiments described above and modified examples thereof. Therefore, redundant explanations are omitted.

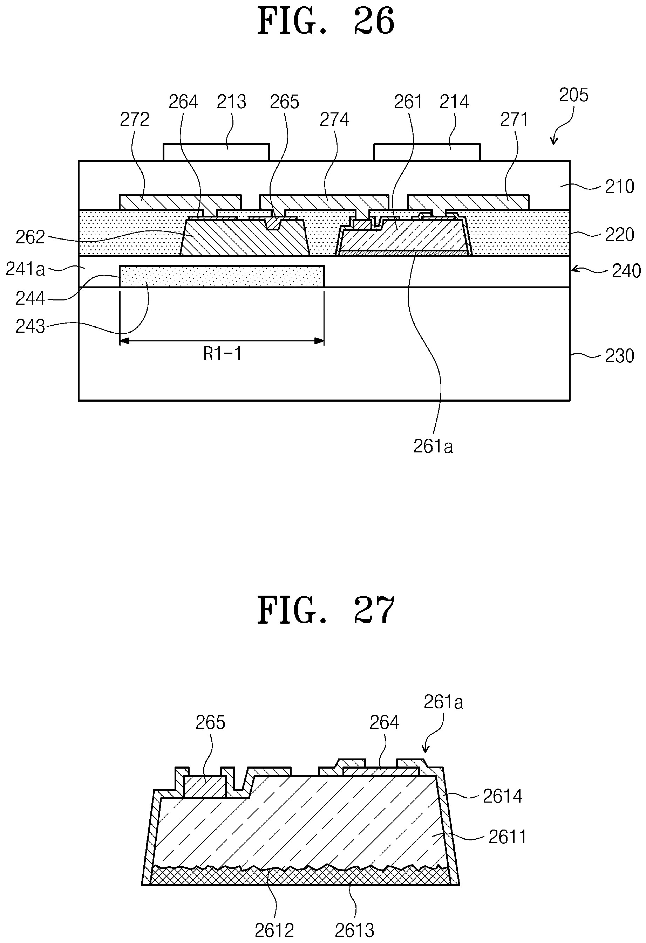

FIG. 26 is a cross-sectional view of a light-emitting element package according to a fifth embodiment of the present disclosure. FIGS. 27 to 29 are cross-sectional views showing a light-emitting element of a light-emitting element package according to the fifth embodiment of the present disclosure.

Referring to FIG. 26, a light-emitting element package 205 according to the fifth embodiment may include the first layer (support layer) 210 having the terminal portions 211, 212, 213, and 214, the second layer (light-emitting layer) 220 located adjacent to the first layer 210 and including the light-emitting elements 261, 262, 263; 260 that define a unit subpixel, the third layer (transmissive layer) 230 through which light emitted from the light-emitting portion 260 passes, and scattering structures 2613 and 2615 included in at least one of the light-emitting elements 261, 262, and 263.

Referring to FIG. 27, at least one 261a of the light-emitting elements 261, 262, and 263 may include a semiconductor layer 2611 and the scattering structure 2613 in which an interface 2612 located on the semiconductor layer 2611 and facing the semiconductor layer 2611 is formed as a rough surface. A passivation layer 2614 may be located outside the scattering structure 2613 and the semiconductor layer 2611.

As such, in some embodiments, each of the light-emitting elements 261, 262, and 263 may include the scattering structure 2613 without including a separate scattering layer.

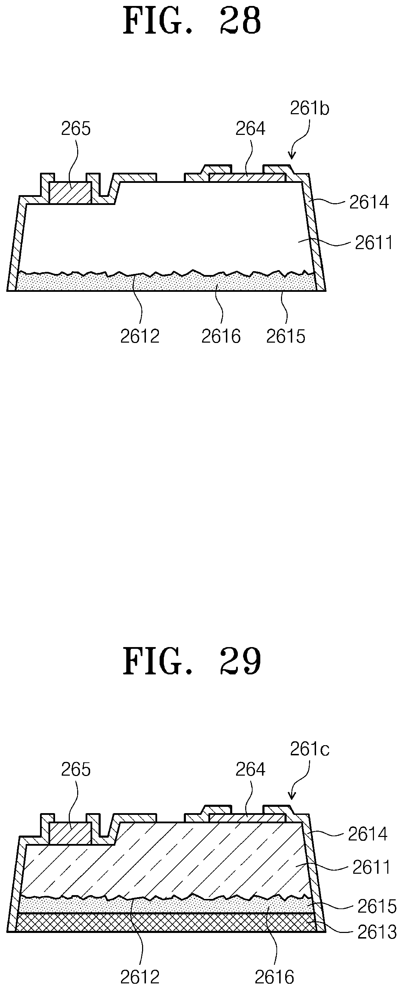

Referring to FIG. 28, at least one 261b of the light-emitting elements 261, 262, and 263 may include the scattering structure 2615 including scattering particles 2616.

Referring to FIG. 29, these two types of scattering structures 2613 and 2615 may be used together.

The scattering structures 2613 and 2615 may be formed during a process of transferring the light-emitting elements 261, 262, and 263 during a fabrication process of the light-emitting elements 261, 262, and 263. For example, the scattering structures 2613 and 2615 may be polymer bonding layers that attach the semiconductor layer 2611 formed on a growth substrate to a temporary substrate (not shown).

Referring back to FIG. 26, the scattering portion 244 having the first-1 region R1-1 described above may be located on the scattering layer 240 at a position corresponding to a light-emitting element other than the light-emitting elements 261, 262, and 263 having the scattering structures 2613 and 2615.

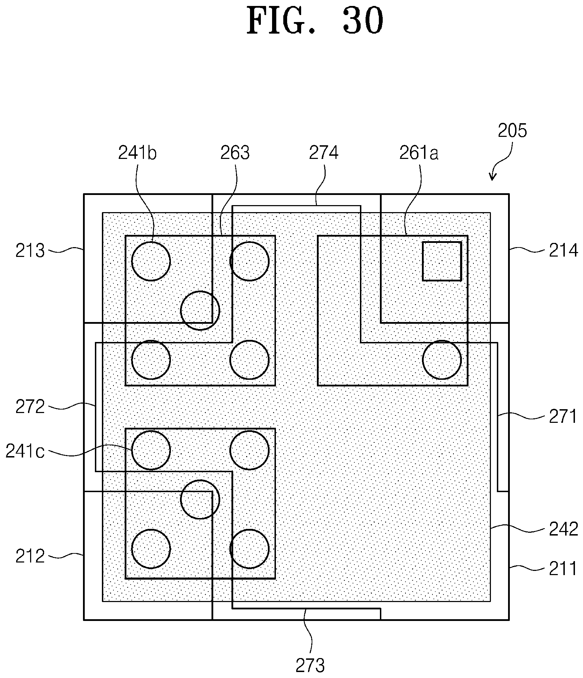

FIG. 30 is a plan view showing a modified example of a light-emitting element package according to the fifth embodiment of the present disclosure.

Referring to FIG. 30, the scattering portion 242 including the column portions 241b and 241c described in the fourth embodiment may be used together with the light-emitting elements 261, 262, and 263 having the scattering structures 2613 and 2615.

For example, the red light-emitting element 261a may include the scattering structures 2613 and 2615, and the second column portion 241c may be located at a position corresponding to the green light-emitting element 263, and the third column portion 241b may be located at a position of the blue light-emitting element 263.

Any parts not otherwise described may be applied in the same way to the description of the first to fourth embodiments described above and modified examples thereof. Therefore, redundant explanations are omitted.

FIG. 31 is a plan view of a light-emitting element package according to a sixth embodiment of the present disclosure. FIG. 32 is a cross-sectional view of a light-emitting element package according to the sixth embodiment of the present disclosure. FIG. 32 shows a cross-section along line B-B' of FIG. 31.

Referring to FIGS. 31 and 32, the light-emitting element package 200 according to the sixth embodiment may include the first layer (support layer) 210 having the terminal portions 211, 212, 213, and 214, the second layer (light-emitting layer) 220 located adjacent to the first layer 210 and including the light-emitting elements 261, 262, 263; 260 that define a unit subpixel, the third layer (transmissive layer) 230 through which light emitted from the light-emitting portion 260 passes, and a scattering layer located between the light-emitting layer 220 and the transmissive layer 230 and including the scattering portion 242 located at a position corresponding to at least some of the light-emitting portion 260 and including the filler particles 243.

As an exemplary embodiment, the light-emitting elements 261, 262, and 263 may include a coating layer 231 including fourth filler particles.

Referring to FIG. 32, connecting electrodes 271a and 272a may have a reflective cup shape that reflects light emitted from the light-emitting elements 261, 262, and 263 toward the scattering layer 242.

As an exemplary embodiment, a light extractor 242b having a rough surface may be provided at an end side of the scattering layer 242. In this case, the connecting electrodes 271a and 272a may have a shape corresponding to the light extractor 242b.

FIGS. 33 to 35 are schematic cross-sectional views illustrating a manufacturing process of a light extractor of a light-emitting element package according to the sixth embodiment of the present disclosure.

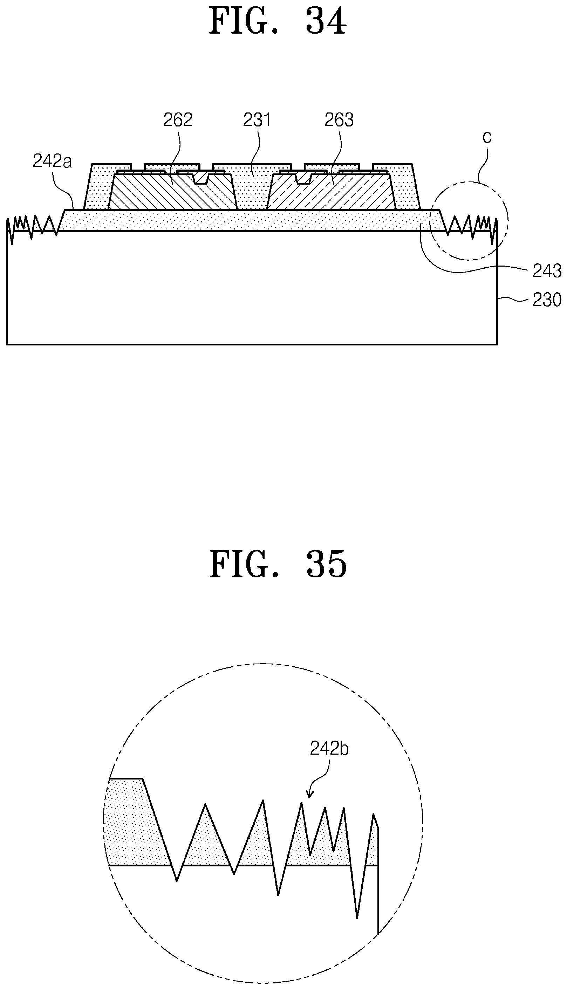

When a layer including the filler particles 243 is dry-etched in a state of FIG. 33, etching selectivity between the filler particles 243 and a binder that defines a layer is different, and thus a rough surface may be formed on an etched surface as shown in FIG. 34. FIG. 35 is an enlarged view of part c of FIG. 34.

When a metal is deposited to form the connecting electrodes 271a and 272a on the roughened surface, the reflectivity of the metal may be reduced. This may be because light absorption by a medium increases due to a reflection path during a process of light scattering and multiple reflections on a rough surface. The resulting reduction in reflectivity may help improve a contrast ratio of a display device.

FIG. 36 is a schematic cross-sectional view showing a display device using a light-emitting element package according to the first embodiment of the present disclosure.

FIG. 36 shows an example of a display device 10 in which the light-emitting element package 200 is used as a unit pixel, according to the first embodiment described with reference to FIGS. 5 and 6.

Referring to FIG. 36, the display device 10 may be configured by arranging light-emitting element packages 200 at regular intervals on a wiring substrate 100 including a substrate 110 having wiring electrodes 120 formed thereon, in a reversed state of FIG. 6.

For example, the wiring electrodes 121 and 122 and the terminal portions 211 to 214 of the light-emitting element package 202 may be electrically connected by a first wiring 123 and a second wiring 124.

The above description is provided merely by way of example to illustrate the present invention, and it will be understood by those of ordinary skill in the art that various modifications and changes may be made without departing from the essential features of the invention.

Accordingly, the embodiments disclosed herein are intended to describe, not to limit, the scope of the invention, and the scope of the invention should not be construed as being limited by these embodiments.

The scope of protection of the present invention shall be defined by the following claims, and all modifications or equivalents falling within the scope of the claims shall be construed as being included within the scope of the invention.

### INDUSTRIAL APPLICABILITY

According to the present disclosure, it is possible to provide a light emitting device package using a light emitting device and a display device using the same.

## Claims

1. A light-emitting element package comprising:
a first layer including a terminal portion;
a second layer that is located adjacent to the first layer and includes a light-emitting portion having light-emitting elements defining a unit subpixel;
a third layer through which light emitted from the light-emitting portion is emitted; and
a fourth layer that is located between the second layer and the third layer and includes a scattering portion located in a first region that locally defines a position corresponding to at least a portion of the light-emitting portion and including first filler particles.

2. The light-emitting element package of claim 1, wherein the first region corresponds to a position of at least one of the light-emitting elements.

3. The light-emitting element package of claim 1, wherein the fourth layer further includes a second region that overlaps at least a portion of the first region and includes second filler particles.

4. The light-emitting element package of claim 3, wherein a refractive index of the first filler particles is different from a refractive index of the second filler particles.

5. The light-emitting element package of claim 1, further comprising a first-1 region located adjacent to the first region and including third filler particles.

6. The light-emitting element package of claim 1, wherein the fourth layer includes a transparent layer that defines the first region.

7. The light-emitting element package of claim 1, further comprising a column portion located at a position overlapping the light-emitting element in the first region.

8. The light-emitting element package of claim 7, wherein the column portion includes:
a first column portion located on a first light-emitting element; and
a second column portion located on a second light-emitting element.

9. The light-emitting element package of claim 8, wherein the first column portion and the second column portion have different sizes.

10. The light-emitting element package of claim 1, wherein the light-emitting element includes a coating layer including fourth filler particles.

11. The light-emitting element package of claim 1, further comprising a connection electrode located between the first layer and the second layer and selectively connecting the light-emitting elements to the terminal portion.

12. The light-emitting element package of claim 1, wherein the scattering portion includes a transparent insulating layer in which the first filler particles are dispersed.

13. The light-emitting element package of claim 1, wherein at least one of the light-emitting elements includes:
a semiconductor layer; and
a scattering structure that is located on the semiconductor layer and has an interface facing the semiconductor layer, the interface being formed as a rough surface.

14. The light-emitting element package of claim 13, wherein the scattering structure includes fifth filler particles.

15. A light-emitting element package comprising:
a support layer including a terminal portion;
a light-emitting layer that is located adjacent to the support layer and includes a light-emitting portion having light-emitting elements defining a unit subpixel;
a transmissive layer through which light emitted from the light-emitting portion is emitted; and
a scattering layer that is located between the light-emitting layer and the transmissive layer and includes a scattering portion located at a position corresponding to at least a portion of the light-emitting portion and including first filler particles.

16. The light-emitting element package of claim 15, wherein the scattering portion is located in a first region locally defined within the scattering layer.

17. The light-emitting element package of claim 16, wherein the first region corresponds to a position of at least one of the light-emitting elements.

18. The light-emitting element package of claim 16, wherein the scattering layer further includes a second region that overlaps at least a portion of the first region and includes second filler particles.

19. The light-emitting element package of claim 15, wherein a light extractor having a rough surface is provided at an end side of the scattering layer.

20. A display device including a light-emitting element package defining individual pixels,
wherein the light-emitting element package includes:
a second layer that is located adjacent to a first layer and includes a light-emitting portion having light-emitting elements defining a unit subpixel;
a third layer through which light emitted from the light-emitting portion is emitted; and
a fourth layer that is located between the second layer and the third layer and includes a scattering portion located in a first region that locally defines a position corresponding to at least a portion of the light-emitting portion and including first filler particles.
